# EUROPEAN PATENT APPLICATION

(11) **EP 4 357 796 A1**
(43) Date of publication of application: **24.04.2024**
(21) Application number: 23196895.9
(22) Date of filing: 12.09.2023
(51) Int. Cl.: G01R 31/36, G01R 31/392

(54) **METHOD, SYSTEM, AND APPARATUS FOR USING A REFERENCE CELL TO MONITOR A BATTERY CELL CONDITION**

(30) Priority: 18.10.2022 IN 202211059504
(71) Applicant: Honeywell International Inc., Charlotte, NC 28202 (US)
(72) Inventor: KUMAR, Nirmal A., Charlotte, 28202 (US)
(74) Representative: Haseltine Lake Kempner LLP

(57) **Abstract**

A system, device, and method for monitoring the health condition of load-bearing battery cells are provided. An example system may include a battery pack containing load-bearing battery cells electrically connected to a load. The system may further include a reference device housing a reference battery cell, a battery charger/discharger, and a sensing device. The reference battery cell may be subjected to a greater number of charge/discharge cycles than the load-bearing battery cells. The system may further include a battery management device, wherein the battery management device monitors the load current on the load-bearing battery cells, and transmits a reference current corresponding to the load current to the reference device, such that the reference current is applied to the reference battery cell. The health condition of the load-bearing battery cells may then be determined based on the condition of the reference battery cell.

## Description

### TECHNOLOGICAL FIELD

Embodiments of the present disclosure relate generally to monitoring the condition of battery cells, and more particularly to utilizing a reference cell to determine the condition of operating battery cells.

### BACKGROUND

Applicant has identified many technical challenges and difficulties associated with monitoring the condition of battery cells during operation. Through applied effort, ingenuity, and innovation, Applicant has solved problems related to determining the condition of operating battery cells by developing solutions embodied in the present disclosure, which are described in detail below.

### BRIEF SUMMARY

Various embodiments are directed to an example method, apparatus, and system for utilizing a reference cell to determine the condition of a battery cell.

In accordance with some embodiments of the present disclosure, an example system for monitoring a health condition of a battery cell is provided. In some embodiments, the system may comprise a battery pack electrically connected to a load, the battery pack comprising one or more load-bearing battery cells, a reference device comprising a reference battery cell, a battery charger/discharger electrically connected to the reference battery cell, and a sensing device positioned to measure a physical characteristic of the reference battery cell. In some embodiments, the reference battery cell may be subjected to a first number of charge/discharge cycles and the one or more load-bearing battery cells may be subjected to a second number of charge/discharge cycles, such that the first number of charge/discharge cycles is greater than the second number of charge/discharge cycles. In some embodiments, the system may further comprise a battery management device communicatively connected to the battery pack and the reference device, wherein the battery management device receives a load current corresponding to a current required by the load, wherein the battery management device transmits a reference current corresponding to the load current, and wherein the reference current is applied to the reference battery cell of the reference device, such that the health condition of the one or more load-bearing battery cells is determined based on the measured physical characteristic of the reference battery cell.

In some embodiments, the reference device further comprises a housing defining a compartment physically separated from a the one or more load-bearing battery cells, and wherein the reference battery cell is disposed within the compartment.

In some embodiments, the reference battery cell may be subjected to charge/discharge cycles, such that the first number of charge/discharge cycles is greater than the second number of charge/discharge cycles, before being disposed within the compartment of the reference device.

In some embodiments, the sensing device may comprise at least one of an ultrasonic transducer, a voltage sensor, and a temperature sensor.

In some embodiments, the reference device may further comprise a representative battery cell, wherein the representative battery cell is subjected to a third number of charge/discharge cycles, wherein the third number of charge/discharge cycles is substantially equivalent to the second number of charge/discharge cycles associated with the number of charge/discharge cycles of the one or more load-bearing battery cells, and wherein the third number of charge/discharge cycles is less than the first number of charge/discharge cycles associated with the number of charge/discharge cycles of the reference battery cell.

In some embodiments, a second sensing device may be positioned proximate the representative battery cell to measure a physical characteristic of the representative battery cell.

In some embodiments, the second sensing device may comprise at least one of an ultrasonic transducer, a voltage sensor, and a temperature sensor.

In some embodiments, a comparison may be made between the physical characteristic of the reference battery cell and the physical characteristic of the representative battery cell, wherein the health condition of the one or more load-bearing battery cells is determined based at least in part on the comparison.

In some embodiments, the physical characteristic compared may be at least one of an amplitude of a received ultrasonic signal, a voltage difference across a first and second terminal of the battery cell, and a temperature proximate the battery cell.

An example reference device for monitoring a health condition of one or more load-bearing cells subjected to a load current is further provided. In some embodiments, the apparatus may comprise a reference battery cell, a battery charger/discharger electrically connected to the reference battery cell; and a sensing device positioned to measure a physical characteristic of the reference battery cell. Further, the reference battery cell may be subjected to a first number of charge/discharge cycles and the one or more load-bearing battery cells may be subjected to a second number of charge/discharge cycles, such that the first number of charge/discharge cycles is greater than the second number of charge/discharge cycles. In addition, a reference current corresponding to the load current may be applied to the reference battery cell, such that the health condition of the one or more load-bearing battery cells is determined based on the measured physical characteristic of the reference battery cell.

In some embodiments, the reference device may further comprise a housing defining a compartment physically separated from a the one or more load-bearing battery cells, wherein the reference battery cell is disposed within the compartment.

In some embodiments, the reference battery cell may be subjected to charge/discharge cycles, such that the first number of charge/discharge cycles is greater than the second number of charge/discharge cycles, before being disposed within the compartment of the reference apparatus.

In some embodiments, the sensing device may comprise at least one of an ultrasonic transducer, a voltage sensor, and a temperature sensor.

In some embodiments, the reference device may further comprise a representative battery cell, wherein the representative battery cell is subjected to a third number of charge/discharge cycles, such that the third number of charge/discharge cycles is substantially equivalent to the second number of charge/discharge cycles associated with the number of charge/discharge cycles of the one or more load-bearing battery cells, and wherein the third number of charge/discharge cycles is less than the first number of charge/discharge cycles associated with the number of charge/discharge cycles of the reference battery cell.

In some embodiments, a second sensing device may be positioned proximate the representative battery cell to measure a physical characteristic of the representative battery cell.

In some embodiments, the second sensing device may comprise at least one of an ultrasonic transducer, a voltage sensor, and a temperature sensor.

In some embodiments, a comparison may be made between the physical characteristic of the reference battery cell and the physical characteristic of the representative battery cell, wherein the health condition of the one or more load-bearing battery cells is determined based at least in part on the comparison.

An example method for monitoring one or more load-bearing battery cells is further provided. In some embodiments, the method may comprise determining a load current, wherein the load current corresponds to a current required by a load electrically connected to the one or more load-bearing battery cells. In addition, the method may comprise causing a battery charger/discharger electrically connected to a reference battery cell to apply a reference current, substantially equivalent to the load current, or derived from the load current, to the reference battery cell. In some embodiments, the reference battery cell may be subjected to a first number of charge/discharge cycles and the one or more load-bearing battery cells may be subjected to a second number of charge/discharge cycles, such that the first number of charge/discharge cycles is greater than the second number of charge/discharge cycles. The method may further comprise, receiving a physical characteristic of the reference battery cell from a sensing device, wherein the sensing device is positioned to measure a physical characteristic of the reference battery cell. Further the method may comprise determining a health condition of the reference battery cell based at least in part on the physical characteristic; and performing an action with reference to the one or more load-bearing battery cells, based on the health condition of the reference battery cell.

In some embodiments, the method may further comprise receiving a physical characteristic of a representative battery cell, wherein the representative battery cell is subjected to a third number of charge/discharge cycles, such that the third number of charge/discharge cycles is substantially equivalent to the second number of charge/discharge cycles associated with the number of charge/discharge cycles of the one or more load-bearing battery cells, and wherein the third number of charge/discharge cycles is less than the first number of charge/discharge cycles associated with the number of charge/discharge cycles of the reference battery cell. In addition, a second sensing device may be positioned proximate the representative battery cell to measure a physical characteristic of the representative battery cell. In some embodiments, the method may compare the physical characteristic of the reference battery cell and the physical characteristic of the representative battery cell; and determining the health condition of the one or more load-bearing battery cells based at least in part on the comparison between the physical characteristic of the reference battery cell and the physical characteristic of the representative battery cell.

In some embodiments, performing an action with reference to the one or more load-bearing battery cells may comprise electrically disconnecting the load from the one or more load-bearing cells.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates a block diagram of an example battery management system utilizing a reference cell device in accordance with an example embodiment of the present disclosure.
FIG. 2 illustrates an example battery pack powering a load in accordance with an example embodiment of the present disclosure.
FIG. 3 illustrates an example reference cell device including a reference cell and a representative cell in accordance with an example embodiment of the present disclosure.
FIG. 4A illustrates an example battery cell including a pair of ultrasonic transducers in accordance with an example embodiment of the present disclosure.
FIG. 4B depicts a series of example received signals by a receiving ultrasonic transducer in accordance with an example embodiment of the present disclosure.
FIG. 5A illustrates another example battery pack including a representative cell powering a load in accordance with an example embodiment of the present disclosure.
FIG. 5B illustrates another example reference device including a reference cell in accordance with an example embodiment of the present disclosure.
FIG. 6 illustrates an example block diagram showing example components of a battery management device in accordance with an example embodiment of the present disclosure.
FIG. 7 depicts a flowchart illustrating an example method for predicting the condition of a battery cell in accordance with an example embodiment of the present disclosure.
FIG. 8 depicts a flowchart illustrating another example method for predicting the condition of a battery cell in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with monitoring the condition of a battery cell during operation. As understood by those of skill in the field to which the present disclosure pertains, there are numerous scenarios in which it may be advantageous to monitor and predict the condition of a battery cell while the battery cell is in use.

Batteries (e.g., lithium-ion batteries, lithium-polymer batteries, etc.) may undergo a chemical reaction within a battery cell to supply power to various devices. Devices requiring substantial amounts of power, such as electric vehicles, may contain tens or even hundreds of battery cells in a battery pack. Battery cells in a battery pack may be susceptible to a number of conditions, even dangerous conditions, as a result of mechanical, electrical, and/or thermal stress and abuse. In some instances, the stress and abuse of the battery cells may be immediate and apparent which may result in an instantaneous dangerous battery condition. For example, a battery cell on an electric vehicle may be punctured or ruptured by flying debris, leading to a thermal runaway event.

However, in many instances, long-term abuse of a battery over an extended period of time may also lead to a dangerous battery condition. Overcharging, over-discharging, exposure to high and low temperatures, impacts to the battery pack, and/or physical damage to the battery pack, may all effect the internal operation of the battery, especially when the abuse occurs over an extended period of time. In some instances, mechanical abuse, such as a crushing force on a battery cell may lead to an internal short circuit. A short circuit may in turn increase the internal heat in the battery cell triggering a thermal runaway condition. In some instances, chronic overcharging and/or discharging may lead to plating and the formation of dendrites, which may subsequently cause short circuits. In addition, in some instances, the chemical properties of the chemicals within the battery cell may slowly change over time due to mechanical, thermal, and electrical abuses. This type of long-term abuse leading to dangerous battery conditions is often referred to as a latent effect or ghost effect. Latent effects due to long-term abuse can be difficult to identify before the battery condition has deteriorated to a point at which chain reactions and eventual combustion may be impossible to stop.

Current battery management systems may utilize various sensors in close proximity to the battery cells to determine the condition of the battery cell based on the physical characteristics around the battery cell. For example, a temperature sensor may be placed on or near the surface of the battery cell. When the temperature measurement exceeds a pre-determined max operating temperature, the battery management system may issue a warning or alert. Similarly, a gas sensor may be placed near the battery cells configured to detect certain gasses which are released when a thermal runaway event has begun. Once those gasses are detected, the battery management system may alert the presence of a dangerous battery condition. However, these battery management systems often do not issue warnings until the battery condition (e.g., thermal runaway) has already started. Due to the irreversible nature of a thermal runaway event, often, once the thermal runaway event has started, it cannot be stopped. As such, in some instances the battery cell will continue to overheat and eventually combust even after the condition is detected and the warning issued. Additionally, the overheating and combustion from a single battery cell may propagate to adjacent battery cells, in some instances leading to a battery pack explosion.

The various example embodiments described herein utilize various techniques to determine the battery condition of an operating battery cell. For example, in some embodiments, a reference cell device may be utilized in a battery management system. The reference cell device may include a reference cell and in some instances may also include a representative cell. The reference cell may be a battery cell that has been artificially or naturally aged. For example, the reference cell may be exposed to multiple charge and discharge cycles before being inserted into the reference cell device. By exposing the reference cell to a series of charges and discharges (e.g., charge/discharge cycles), the health condition of the reference cell is weakened.

The reference cell device may further include a battery charger/discharger capable of applying a positive or negative current to the battery cells within the reference cell device. For example, in some embodiments, the battery management system may monitor the load current required by each of the battery cells in the battery pack (hereinafter referred to as load-bearing cells). The battery management system may configure the battery charger/discharger to apply an equivalent current to the reference cells in the reference cell device. Thus, any dangerous battery conditions due to internal battery cell disturbances are likely to occur in the weakened reference cell before they occur in the new and fresh active cell (e.g., load-bearing cell) that has not been subjected to additional charge and discharge cycles. In such a system, the physical characteristics of the reference cell may be closely monitored. In the event that a physical characteristic indicative of a dangerous battery condition is detected (e.g., a sharp increase in temperature and/or the presence of certain gasses) in the reference cell the battery management system may determine the degradation of health is likely to occur in the load-bearing cells. Based on this determination, the battery management system may decide to cutoff power to the load-bearing cells, service the battery system, alert the user, administer further testing on the load-bearing cells, and/or perform similar actions.

In some embodiments, the reference cell device may further include a battery cell that has not been exposed to additional charge and discharge cycles (e.g., representative cell). The representative cell may closely approximate the health condition of the load-bearing cells. The reference cell may also be exposed to the reference current from the battery charger/discharger as configured by the battery management system. The reference cell may additionally include various sensing devices, such as a temperature sensor, voltage sensor, and ultrasonic transducer to measure the physical characteristics of the representative cell. The measurements from the sensors proximate the representative cell may be compared to the reference cell to provide further insight into the health of the load-bearing cells.

As a result of the herein described example embodiments and in some examples, the ability to monitor the health of an operating battery and take action to mitigate any decline in health before reaching a dangerous condition may be greatly improved. In addition, the safety of operating devices utilizing battery packs, specifically electric cars, may similarly be improved.

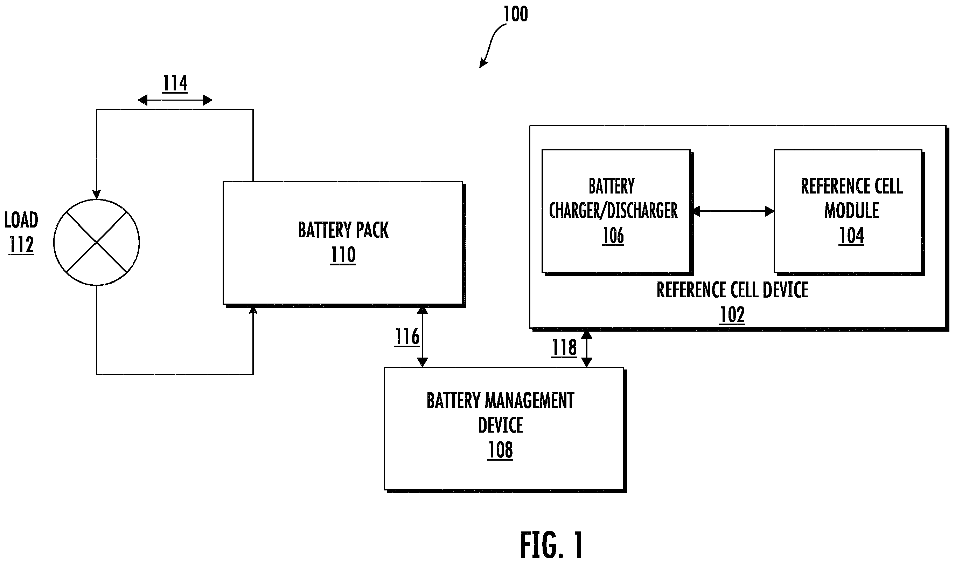

Referring now to FIG. 1, a block diagram of an example battery monitoring system 100 is provided. The depicted example battery monitoring system 100 of FIG. 1, includes a battery pack 110 electrically connected to a load 112 requiring a load current 114 and communicatively connected to a battery management device 108 via battery pack communication channel 116. The example battery monitoring system 100 further includes a reference cell device 102 also communicatively connected to the battery management device 108 via reference cell communication channel 118. The reference cell device 102 as depicted in FIG. 1 includes a battery charger/discharger 106 electrically connected to a reference cell module 104.

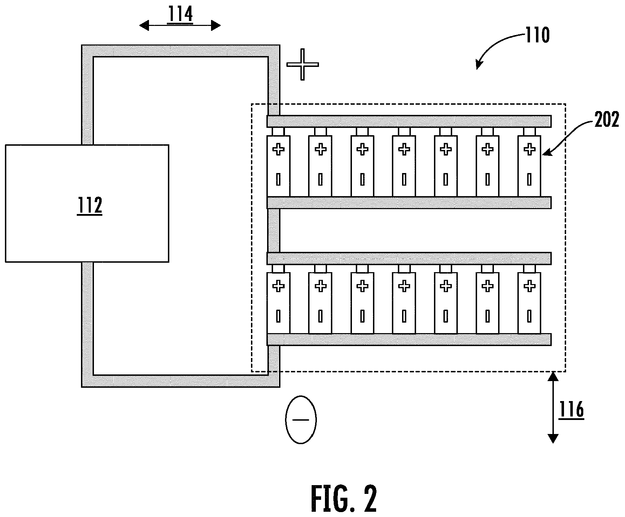

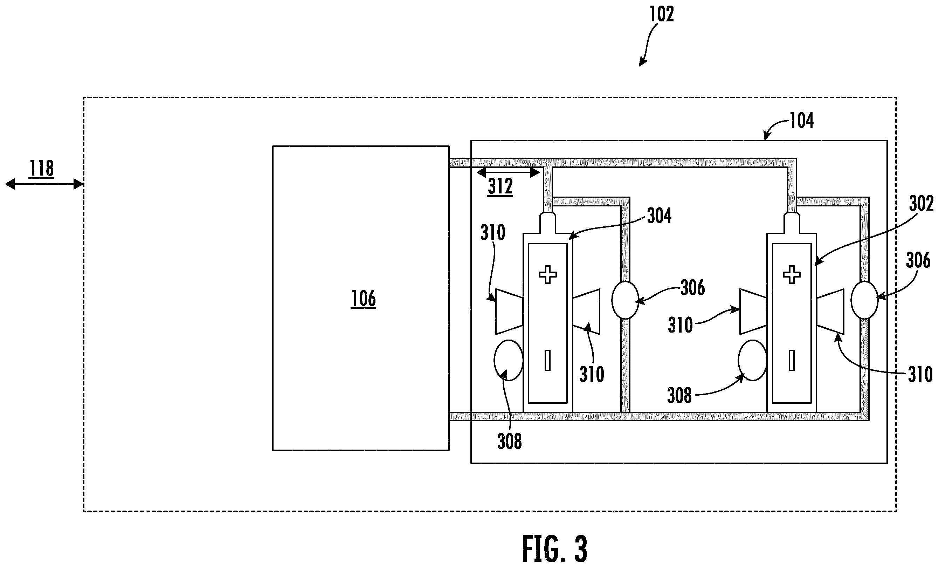

As depicted in FIG. 1, an example battery monitoring system 100 includes a battery pack 110. A battery pack 110 may be any network, system, and/or housing of one or more battery cells, utilizing chemical reactions to supply a load current 114 to a load 112, such as an electric vehicle. In general, a battery cell (e.g., load-bearing cell 202 as depicted in FIG. 2, reference cell 302 as depicted in FIG. 3, representative cell 304 as depicted in FIG. 3) utilizes a chemical reaction to supply power to produce an output power supply, having a current such as load current 114. As an example, when the battery pack 110 is discharging, ions move from the positive electrode/terminal to the negative electrode/terminal, releasing free electrons and providing an electric load current 114 to the load 112 (e.g., an electric car). A battery cell may contain a large variety of chemical compositions (e.g., lithium-nickel-manganese-cobalt oxides, lithium-iron phosphates, etc.). The chemical reactions occurring in these batteries can be susceptible to dangerous battery conditions, such as thermal runaway events. In thermal runaway events, the chemical reactions generate heat faster than the heat may be dissipated and the temperature of the battery cell increases uncontrollably until the cell combusts. The output power supply necessary to operate an electric vehicle can be quite extensive, requiring a significant number battery cells and a significant number of chemical reactions. Many electric vehicles today have begun arranging large numbers of battery cells into a battery pack 110 that is integrated as part of the body of the electric vehicle. This technology has largely come to be known as cell-to-chassis technology. Such battery packs 110 may be particularly prone to thermal runaway and eventual combustion as a result of mechanical, electrical and/or thermal stress and abuse. In some embodiments, a battery pack 110 may further include one or more sensing devices. For example, voltage sensors, temperature sensors, gas sensors, and other similar sensing devices. In some embodiments, voltage sensors may be utilized to measure the load current 114 and/or the current passing through one or more individual load-bearing cells 202. The measurements obtained by the sensing devices disposed on or near the battery pack 110 may, in some embodiments, be transmitted to the battery management device 108 via a battery pack communication channel 116.

As further depicted in FIG. 1, an example battery monitoring system 100 includes a load 112. A load 112 may be any device or process that requires power generated by the battery pack 110 during operation. A load 112 may be for example a motor, such as a motor for an electric vehicle, a digital device, or other similar device. In addition, the load 112 may represent any device or process that recharges the battery pack 110, such as a charging device.

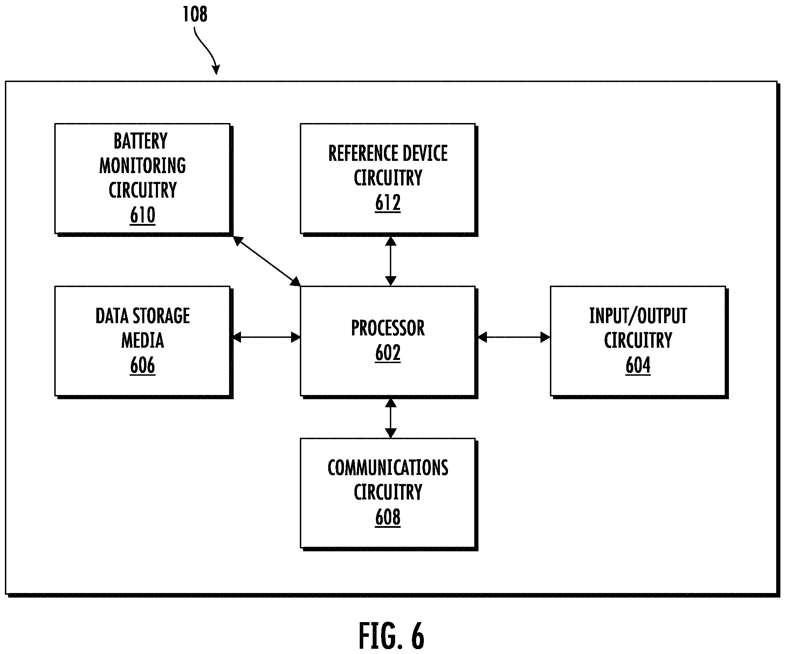

As depicted in FIG. 1, an example battery monitoring system 100 includes a battery management device 108. A battery management device 108 may be any device, apparatus, circuitry, or other similar mechanism embodied in either hardware or a combination of hardware and software that is configured to receive input data related to the state of the battery pack 110 and the reference cell device 102 through communication channels (e.g., battery pack communication channel 116, reference cell communication channel 118), for example, a controller area network (CAN) bus, or an inter-integrated circuit (I2C) bus. As an example, the battery management device 108 may comprise a form such as that shown in FIG. 6.

In some embodiments, the battery management device 108 may receive data related to the load demands on the battery pack 110 via battery pack communication channel 116. Data related to the load demands on the battery pack 110 may include, for example, the total current required by the load 112 (e.g., load current 114), the number of battery cells within the battery pack 110, the physical configuration of the battery cells, and other similar data. In some embodiments, the battery management device 108 may determine the overall load current and/or the current applied to each of the individual battery cells or group of battery cells within the battery pack 110. In addition, the battery management device 108 may determine the reference current to be applied by the reference cell device 102 and transmit configure and control commands to configure the battery charger/discharger 106 via the reference cell communication channel 118.

In some embodiments, the battery pack 110 and reference cell device 102 may further include sensing devices. In some embodiments, the battery management device 108 may receive and monitor periodic sensor data related to the physical condition of the battery pack 110 and the reference cell device 102. The battery management device 108 may receive such data by periodic request, and/or by automated update from one or more of the sensing devices. For example, a sensing device, such as a pressure sensor may be configured to report a data reading every 5 milliseconds. The pressure sensor may then determine the pressure reading and transmit the current pressure reading to the battery management device 108 every 5 milliseconds. When the battery management device 108 receives periodic updates of a sensor reading, the battery management device 108 may determine a battery condition (e.g., thermal runaway).

In addition to determining the state of the battery pack 110 and/or reference cell device 102, the battery management device 108 may initiate and/or perform an action based on the state. Actions performed by the battery management device 108 may include disabling power to the reference cell device and/or the reference cell module 104. Actions performed may further include disabling power to the battery pack 110 and/or disconnecting the load 112 from the battery pack 110. Further actions may include initiating additional testing on the battery pack 110 and/or the reference cell module 104 to further determine the battery condition. Actions may further include notifying a user through an alarm, pop-up, or any other alert mechanism. In addition, in some embodiments, the battery management device 108 may initiate mitigating actions based on the condition of the battery pack 110 and/or reference cell device 102.

As further depicted in FIG. 1, an example battery monitoring system 100 includes a reference cell device 102. As shown in FIG. 1, the example reference cell device 102 additionally includes a battery charger/discharger 106 electrically connected to a reference cell module 104. In some embodiments, the reference cell device 102 may receive command and control messages transmitted from the battery management device 108. These messages may include data related to the configuration of the battery charger/discharger such that the battery charger/discharger 106 applies a current to the reference cell module 104 associated with the load current 114. In addition, the reference cell device 102, in some embodiments, may transmit data related to the physical condition of the reference cell module 104 to the battery management device 108 to determine the condition of the reference cells.

Referring now to FIG. 2, a detailed view of an example battery pack 110 and connected load 112 is provided. As shown in FIG. 2, the example battery pack 110 includes a plurality of battery cells (e.g., load-bearing cell 202) electrically connected using a combination of series and parallel connections within the battery pack 110. The battery pack 110 may further include a positive and a negative terminal which may be electrically connected to the load 112. The electrical connection between the battery pack 110 and the load 112 facilitates the flow of current (e.g., load current 114) from the battery pack 110 to the load 112 or vice versa if the load 112 is replaced with a charger. As shown in FIG. 2, the example battery pack 110 further includes a battery pack communication channel 116 providing a communicative connection between the battery pack and other components of the battery monitoring system 100, for example, the battery management device 108.

As depicted in FIG. 2, the example battery pack 110 includes a plurality of load-bearing cells 202. A load-bearing cell 202 may refer to any battery cell utilized to provide power to the load 112 having a current such as load current 114. A load-bearing cell 202 may be contrasted with a reference cell 302 (as described in FIG. 3) that may not contribute to the output power provided to the load 112. In addition, a load-bearing cell 202 may receive power having a current, also referred to as load current 114, when the load 112 is replaced with a charger, or a charger is additionally connected to the terminal ports of the battery pack 110. In an instance when power is provided to the battery pack, the load current 114 may be represented by a negative value indicating the flow of current into the battery pack 110. As described in relation to FIG. 1, in general, a battery cell utilizes a chemical reaction to supply an output power, having a current such as load current 114.

As further depicted in FIG. 2, the load-bearing cells 202 within a battery pack 110 may be electrically connected in a combination of series and parallel connections. The physical configuration of the load-bearing cells 202 may be used to customize the output voltage and current of the battery pack 110. In addition, the physical configuration of the load-bearing cells 202 determines the current required of each individual load-bearing cell 202. For example, a plurality of load-bearing cells 202 connected in parallel may increase the available current while the maximum output voltage stays the same. In such an embodiment, the current produced by each battery is a fraction of the total load current 114. In another example, a plurality of load-bearing cells 202 may be connected in series. In such a configuration, the current produced by each of the load-bearing cells 202 is equivalent to the total load current 114. In order to appropriately replicate the current experienced by a load-bearing cell 202, the battery management device 108 may have access to the physical configuration of the plurality of load-bearing cells 202. In some embodiments, the battery pack 110 and/or battery management device 108 may receive real-time measurements indicating the current flowing through one or more individual load-bearing cells 202. The reference current provided by the battery management device 108 to the reference cell device 102 may be based at least in part on the one or more measurements of the individual load-bearing cells 202.

As shown in FIG. 2, in some embodiments, measurements related to the operation of the battery pack 110 may be transmitted to the battery management device 108 via a battery pack communication channel 116. A battery pack communication channel 116 may be any hardware, software, or combination thereof configured to receive and/or transmit data from/to a network and/or any other device, circuitry, or module. For example, in some embodiments, communication between the battery pack 110 and/or sensing devices disposed on or near the battery pack 110 may be supported by a CAN communication channel.

Referring now to FIG. 3, an example reference cell device 102 is provided. As depicted in FIG. 3, the example reference cell device 102 includes a reference cell module 104 containing a reference cell 302 and a representative cell 304 electrically connected to a battery charger/discharger 106 which is supplying a reference current 312. In addition, a voltage sensor 306, temperature sensor 308, and pair of ultrasonic transducers 310 are disposed on or near the reference cell 302 and representative cell 304. Further, as depicted in FIG. 3, the reference cell device 102 is communicatively connected to the battery management device 108 via a reference cell communication channel 118.

As depicted in FIG. 3, the example reference cell device 102 includes a battery charger/discharger 106. A battery charger/discharger 106 may be any hardware, software, or combination of hardware and software capable of receiving command and control messages to configure the output current (e.g., reference current 312) of the battery charger/discharger 106 and applied to one or more battery cells. In some embodiments, the battery charger/discharger 106 may receive command and control signals from a battery management device 108 configuring the battery charger/discharger 106 based on the observed load current 114 and battery cell configuration within the battery pack 110, as described in relation to FIG. 2. A battery charger/discharger 106 may be configured to apply a positive current (e.g., charge current) to the one or more battery cells (e.g., reference cell 302, representative cell 304) contained within the reference cell module 104. In addition, the battery charger/discharger may be configured to apply a negative current (e.g., discharged current) to the one or more battery cells (e.g., reference cell 302, representative cell 304) contained within the reference cell module 104. By providing a mechanism to emulate the load current 114 to the reference cell module 104, a battery management device 108 may detect a battery condition (such as thermal runaway) before it has occurred.

As further depicted in FIG. 3, the example reference cell module 104 includes a reference cell 302. A reference cell 302 may be any battery cell that utilizes a chemical reaction to produce an output power supply. A reference cell 302 may comprise any variety of chemical compositions (e.g., lithium-nickel-manganese-cobalt oxides, lithium-iron phosphates, etc.) in any battery cell shape (e.g., cylindrical cell, rectangular cell, pouch cell).

A reference cell 302 may be subjected to additional charge/discharge cycles when compared to the representative cell 304 and the one or more load-bearing cells 202. A charge/discharge cycle may refer to any measure of a battery cell's exposure to a current requiring movement of the chemical ions from the anode to the cathode, or vice versa. For example, a charge/discharge cycle may refer to the number of times a reference cell 302 has been substantially charged and/or discharged. In some embodiments, the amount of charge and/or discharge may be determined based on the capacity of the battery. For example, a charge/discharge cycle may refer to discharging the battery below a minimum capacity percent (e.g., 15%) and subsequently recharging the battery to above a maximum capacity percent (e.g., 85%). In some embodiments, a charge/discharge cycle may refer to the number of times a specific amount of charge has been transmitted to or from the load-bearing cells 202. For example, a charge/discharge cycle may be measured in Coulombs (current in amps multiplied by the time in seconds). A charge/discharge cycle may correspond to the number of times a pre-determined number of Coulombs has been transferred to and/or from the reference cell 302.

In some embodiments, the reference cell 302 may be subjected to additional charge/discharge cycles based on the maximum number of charge/discharge cycles of the battery as provided by the manufacturer. For example, a manufacturer may indicate the total life of a reference cell 302 in terms of a total number of charge/discharge cycles (e.g., 3000 charge/discharge cycles). In some embodiments, the reference cell 302 may be subjected to additional charge/discharge cycles based on a percentage of the total life of the reference cell 302 as provided by the manufacturer. For example, a reference cell 302 may be subjected to additional charge/discharge cycles equal to 10% of the total charge/discharge signals of the total life of the reference cell 302. In such an example, in an instance in which the total life of the reference cell 302 is 3000 charge/discharge cycles, the number of additional charge/discharge cycles the reference cell 302 is exposed to is 10% of 3000, or 30 charge discharge cycles.

In some embodiments, the reference cell 302 may be subjected to additional charge/discharge cycles (e.g., battery use) previous to installation in the reference cell module 104, for example in a controlled initialization environment. In some embodiments, the reference cell 302 may be subjected to additional charge/discharge cycles by first deploying the reference cell 302 as a load-bearing cell in a system. As a load-bearing cell, the reference cell 302 may be exposed to use and therefore additional charge/discharge cycles. Once a pre-determined number of charge/discharge cycles has been reached, the reference cell 302 may be removed from a load-bearing environment and disposed within the reference cell module 104 for use as an indicator of a condition of lesser used battery cells (e.g., load-bearing cells 202). In some embodiments, the reference cell 302 may be subjected to additional charge/discharge cycles through use of a battery charger/discharger, similar to the battery charger/discharger 106. In such an embodiment, the battery charger/discharger may be used to subject the reference cell 302 to additional charge/discharge cycles. Once the pre-determined target number of charge/discharge cycles has been reached, the reference cell 302 may be disposed within the reference cell module 104 for use as an indicator of a condition of lesser used battery cells (e.g., load-bearing cells 202).

In some embodiments, the reference cell 302 may be subjected to additional charge/discharge cycles after disposition in the reference cell module 104. Exposure to additional charge/discharge cycles may occur as part of an initialization process and/or an initialization phase. In addition, exposure to additional charge/discharge cycles may occur throughout the life of the reference cell 302. For example, in some embodiments, the reference cell 302 of the reference cell module 104 may be exposed to additional charge/discharge cycles during an initialization during the reference cell device 102 manufacturing, installation, or a similar system initialization. In one example, the battery charger/discharger 106 may be enabled, or the reference cell 302 may be attached to an external device that may subject the reference cell 302 to a number of charge/discharge cycles before installation in a battery monitoring system 100. In another example, the reference cell 302 may be subjected to additional charge/discharge cycles after installation but during an initialization phase of the battery monitoring system. In some embodiments, the reference cell 302 may be subjected to additional charge/discharge cycles during operation of the battery monitoring system 100, for example, by subjecting the reference cell 302 to additional charge/discharge cycles while the load-bearing cells 202 are idle. In each instance, the reference cell 302 may be subjected to additional charge/discharge cycles as compared to the load-bearing cells 202 to provide information on the condition of a battery cell having a comparatively diminished overall health.

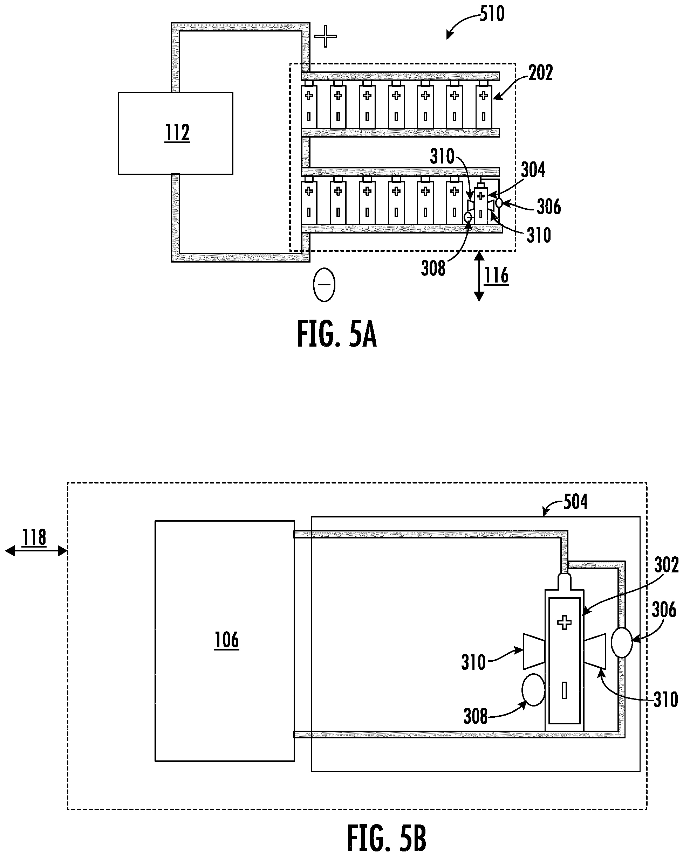

As further depicted in FIG. 3, the example reference cell module 104 includes a representative cell 304. A representative cell 304 may be any battery cell that utilizes a chemical reaction to produce an output power. A representative cell 304 may comprise any variety of chemical compositions (e.g., lithium-nickel-manganese-cobalt oxides, lithium-iron phosphates, etc.) in any battery cell shape (e.g., cylindrical cell, rectangular cell, pouch cell). A representative cell 304 may closely represent the age, use (e.g., charge/discharge cycles), and/or overall health of the one or more load-bearing cells 202. In some embodiments, the representative cell 304 may be from the same manufacturing lot as the one or more load-bearing cells 202. In some embodiments, the number of charge/discharge cycles the representative cell 304 is exposed to will be less than that of the reference cell 302 and substantially equivalent to the number of charge/discharge cycles the one or more load-bearing cells 202 are exposed to. The representative cell 304 may be disposed within the reference cell module 104 to allow for additional measurement devices (e.g., voltage sensor 306, temperature sensor 308, ultrasonic transducers 310) to be disposed on or around the representative cell 304. In some embodiments, the representative cell 304 may be disposed within the battery pack 110, as shown in FIG. 5B. In each instance, the representative cell 304 provides vital information necessary to determine the overall health of the one or more load-bearing cells 202.

As further depicted in FIG. 3, each of the reference cell 302 and representative cell 304 includes a voltage sensor 306. A voltage sensor 306 may be electrically attached to the positive and negative terminals of the corresponding battery cell (e.g., reference cell 302, representative cell 304) to determine electrical properties as related to the battery cell. For example, a voltage sensor 306 may be used to determine the voltage difference across the terminals of the battery cell and/or the current through a battery cell. The voltage difference and/or current may be used to determine the internal resistance of the battery cell. Changes in internal resistance of a battery cell may be indicative of the health of the battery cell. Either a decrease in the internal resistance or an increase in the internal distance may be an indicator of the degradation of the internal components of the battery cell. For example, in an instance in which the separator (internal component separating an anode from a cathode) begins to decay, the internal resistance of the battery cell may decrease, indicating a potential issue with the measured battery cell.

A voltage sensor 306 may be electrically connected to both the reference cell 302 and the representative cell 304. Electrical measurements from both battery cells may be compared. Such a comparison may allow determinations of the condition of the one or more load-bearing cells 202 to be made. A comparison to an aged reference cell 302 may provide indications that a representative cell 304 has aged or warn differently than the reference cell 302. Such an indicator may be an indicator of an approaching onset of a dangerous battery condition, such as thermal runaway.

As further depicted in FIG. 3, each of the reference cell 302 and representative cell 304 includes a temperature sensor 308. A temperature sensor 308 may be positioned on or near the corresponding battery cell (e.g., reference cell 302, representative cell 304) to determine the temperature of the battery cell and/or the surrounding environment. An increase in temperature outside of the normal operating range may be an indicator of an onset of a dangerous battery condition, such as thermal runaway.

A temperature sensor 308 may be electrically connected to both the reference cell 302 and the representative cell 304. Temperature measurements from both battery cells may be compared. Such a comparison may allow determinations of the condition of the one or more load-bearing cells 202 to be made. A comparison to an aged reference cell 302 may provide indications that a representative cell 304 has aged or warn differently than the reference cell 302. Such an indicator may be an indicator of an approaching onset of a dangerous battery condition, such as thermal runaway.

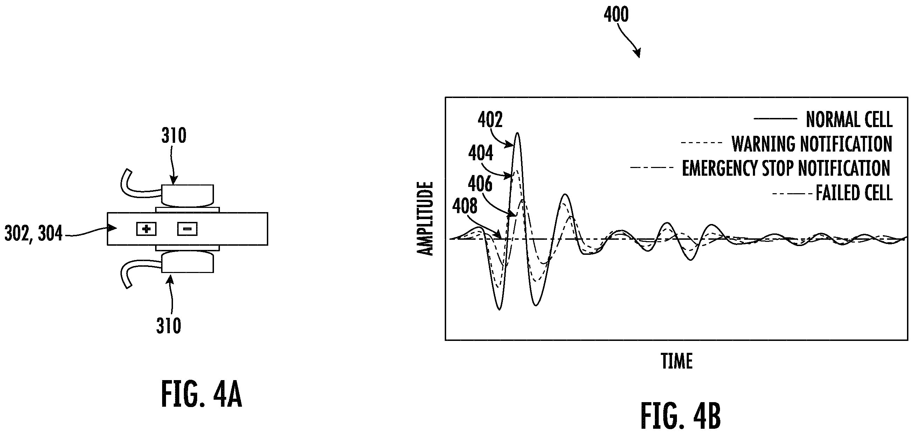

As further depicted in FIG. 3, each of the reference cell 302 and representative cell 304 includes a pair of ultrasonic transducers 310 placed on opposite sides of the corresponding battery cell. As further described in relation to FIG. 4A and FIG. 4B an ultrasonic transducer 310 may transmit an ultrasonic wave from one side of the transducer to be received by the ultrasonic transducer 310 on the opposite side of the battery cell. Analyzing the received wave may provide insight into changes in the internal components of the battery cell. Based on the received ultrasonic wave, a battery management device 108 may determine onset of a dangerous battery condition, such as thermal runway, may be likely. In some embodiments, the pair of ultrasonic transducers 310 may be replaced with an ultrasonic receiver and ultrasonic transmitter.

As further depicted in FIG. 3, the example reference cell device 102 is communicatively connected to other components of the battery monitoring system 100, including the battery management device 108 via a reference cell communication channel 118. The reference cell communication channel 118 may be any hardware, software, or combination thereof configured to receive and/or transmit data from/to a network and/or any other device, circuitry, or module. For example, in some embodiments, communication between the battery management device 108 and the reference cell device 102 and/or sensing devices disposed on or near the reference cell device 102 (e.g., voltage sensor 306, temperature sensor 308, ultrasonic transducers 310) may be supported by a CAN or I2C communication channel. In some embodiments, the reference cell communication channel 118 may be utilized to configure the battery charger/discharger 106 to output the reference current 312 at a level consistent with the real-time load current 114. In addition, in some embodiments, the reference cell communication channel 118 may be utilized to receive measurements related to the physical condition of the battery cells of the reference cell device 102 (e.g., reference cell 302, representative cell 304) to determine a condition of the reference cell 302 and/or representative cell 304, and consequently determine a condition of the one or more load-bearing cells 202.

Referring now to FIG. 4A, a pair of ultrasonic transducers 310 are shown disposed on opposite sides of a battery cell (e.g., reference cell 302, representative cell 304). Ultrasonic transducers 310 may be any device capable of sending and/or receiving ultrasonic waves. In some embodiments, ultrasonic waves may be transmitted through the battery cell, received on the opposite side of the battery cell, and analyzed to determine changes in the internal condition of the cell. In some embodiments, as a battery cell nears or experiences thermal runaway, the internal material properties of the battery may change. Some of these changes may be reflected in the time of flight time of the transmitted signal, the amplitude of the received signal versus the transmitted signal, or any combination thereof. In addition, in some embodiments, the battery cell may experience physical deformations due to overheating and the increased pressure of a dangerous battery condition. In such an instance, the received ultrasonic signal will be further reduced and/or completely disconnected. Early recognition of the reduced ultrasonic signal and/or filed ultrasonic signal in the reference cell device 102 may be a key indicator in determining the likelihood of a similar dangerous condition in the one or more load-bearing cells 202.

FIG. 4B depicts a transducer signal graph 400 representative of the amplitude of a received transmitted wave with respect to time. Line 402 represents the amplitude of the received ultrasonic signal under normal conditions.

As depicted by line 402, when the internal structures of the battery cell are intact, the amplitude of the received ultrasonic signal is at a maximum.

As depicted by line 404, when the internal structures of the battery cell begin to deteriorate and/or the physical condition of the battery cell begins to deform, the received amplitude of the ultrasonic signal is reduced. In such an embodiment, the reduced amplitude of the received ultrasonic signal may be an indicator of the likely onset of a dangerous battery condition. Based in part on the amplitude of the received transducer signal, the battery management device 108 may provide warning of a likely dangerous battery condition (e.g., thermal runaway).

As depicted by line 406, when the internal structure of the battery cell further deteriorates, the amplitude of the received ultrasonic signal may be further diminished. The further reduced amplitude of the received ultrasonic signal may be an indicator of the actual onset, or imminency of a dangerous battery condition. Based in part on the amplitude of the received transducer signal, the battery management device 108 may provide warning of an imminent dangerous battery condition (e.g., thermal runaway) and/or initiate mitigating actions, such as disconnecting the load 112 from the battery monitoring system 100.

As depicted by line 408, when the internal structure of the battery cell deteriorates even further, the receiving ultrasonic transducer 310 may be unable to detect the transmitted ultrasonic signal. The failure to detect a transmitted ultrasonic signal may be an indicator of failure of the battery cell due to physical deformation or interior structure deterioration and the subsequent presence of a dangerous battery condition, such as thermal runaway. Based in part on the lack of a received transducer signal, the battery management device 108 may provide warning of an imminent dangerous battery condition (e.g., thermal runaway) and/or initiate mitigating actions, such as an emergency stop of the battery system.

Referring now to FIG. 5A and FIG. 5B, another example battery pack 510 and corresponding reference cell device 502 are provided. The example battery pack 510 of FIG. 5A includes a representative cell 304, in addition to the one or more load-bearing cells 202 within the battery pack 510. The representative cell 304 of the example battery pack 510 includes a voltage sensor 306, a temperature sensor 308, and a pair of ultrasonic transducers 310, similar to those described in relation to FIG. 3. In some embodiments, the measurements captured by the voltage sensor 306, temperature sensor 308, and ultrasonic transducers 310 may be transmitted to the battery management device 108 via battery pack communication channel 116. In some embodiments, the representative cell 304 of FIG. 5A may be utilized, as with the one or more load-bearing cells 202, to provide power to the load 112 and/or received power when in a charging state. As such, the overall health of the representative cell 304 of FIG. 5A may accurately resemble the overall health of the one or more load-bearing cells 202.

As depicted in FIG. 5B, the example reference cell device 502 includes an example reference cell module 504 containing a reference cell 302 and corresponding sensors (e.g., voltage sensor 306, a temperature sensor 308, and a pair of ultrasonic transducers 310). In some embodiments, a reference cell module 504 may only include a reference cell 302, in contrast to the reference cell module 104 of FIG. 3 which includes a reference cell 302 and a representative cell 304. In such an embodiment, the health condition of the one or more load-bearing cells 202 may be determined based on the measurements of the sensing devices associated with the reference cell 302. In an embodiment in which the corresponding battery pack 510 includes a representative cell 304, the battery management device 108 may compare the measurements of the sensing devices associated with the battery pack 510 with the sensing devices associated with the reference cell 302 to determine the health condition of the one or more load-bearing cells 202.

FIG. 6 illustrates an example battery management device 108 in accordance with at least some example embodiments of the present disclosure. The battery management device 108 includes processor 602, input/output circuitry 604, data storage media 606, communications circuitry 608, battery monitoring circuitry 610, and reference device circuitry 612. In some embodiments, the battery management device 108 is configured, using one or more of the sets of circuitry 602, 604, 606, 608, 610, and/or 612, to execute and perform the operations described herein.

Although components are described with respect to functional limitations, it should be understood that the particular implementations necessarily include the use of particular computing hardware. It should also be understood that in some embodiments certain of the components described herein include similar or common hardware. For example, two sets of circuitry may both leverage use of the same processor(s), network interface(s), storage medium(s), and/or the like, to perform their associated functions, such that duplicate hardware is not required for each set of circuitry. The user of the term "circuitry" as used herein with respect to components of the apparatuses described herein should therefore be understood to include particular hardware configured to perform the functions associated with the particular circuitry as described herein.

Particularly, the term "circuitry" should be understood broadly to include hardware and, in some embodiments, software for configuring the hardware. For example, in some embodiments, "circuitry" includes processing circuitry, storage media, network interfaces, input/output devices, and/or the like. Alternatively or additionally, in some embodiments, other elements of the battery management device 108 provide or supplement the functionality of other particular sets of circuitry. For example, the processor 602 in some embodiments provides processing functionality to any of the sets of circuitry, the data storage media 606 provides storage functionality to any of the sets of circuitry, the communications circuitry 608 provides network interface functionality to any of the sets of circuitry, and/or the like.

In some embodiments, the processor 602 (and/or co-processor or any other processing circuitry assisting or otherwise associated with the processor) is/are in communication with the data storage media 606 via a bus for passing information among components of the battery management device 108. In some embodiments, for example, the data storage media 606 is non-transitory and may include, for example, one or more volatile and/or non-volatile memories. In other words, for example, the data storage media 606 in some embodiments includes or embodies an electronic storage device (e.g., a computer readable storage medium). In some embodiments, the data storage media 606 is configured to store information, data, content, applications, instructions, or the like, for enabling the battery management device 108 to carry out various functions in accordance with example embodiments of the present disclosure.

The processor 602 may be embodied in a number of different ways. For example, in some example embodiments, the processor 602 includes one or more processing devices configured to perform independently. Additionally or alternatively, in some embodiments, the processor 602 includes one or more processor(s) configured in tandem via a bus to enable independent execution of instructions, pipelining, and/or multithreading. The use of the terms "processor" and "processing circuitry" should be understood to include a single core processor, a multi-core processor, multiple processors internal to the battery management device 108, and/or one or more remote or "cloud" processor(s) external to the battery management device 108.

In an example embodiment, the processor 602 is configured to execute instructions stored in the data storage media 606 or otherwise accessible to the processor. Alternatively or additionally, the processor 602 in some embodiments is configured to execute hard-coded functionality. As such, whether configured by hardware or software methods, or by a combination thereof, the processor 602 represents an entity (e.g., physically embodied in circuitry) capable of performing operations according to an embodiment of the present disclosure while configured accordingly. Alternatively or additionally, as another example in some example embodiments, when the processor 602 is embodied as an executor of software instructions, the instructions specifically configure the processor 602 to perform the algorithms embodied in the specific operations described herein when such instructions are executed.

As one particular example embodiment, the processor 602 is configured to perform various operations associated with monitoring one or more load-bearing battery cells. In some embodiments, the processor 602 includes hardware, software, firmware, and/or a combination thereof, that determines a load current (e.g., load current 114), wherein the load current corresponds to a current required by a load (e.g., load 112) electrically connected to the one or more load-bearing battery cells (e.g., load-bearing cells 202). Additionally or alternatively, in some embodiments, the processor 602 includes hardware, software, firmware, and/or a combination thereof, that causes a battery charger/discharger (e.g., battery charger/discharger 106) electrically connected to a reference battery cell (e.g., reference cell 302) to apply a reference current (e.g., reference current 312), substantially equivalent to the load current, or derived from the load current, to the reference battery cell. In some embodiments, the reference battery cell may be subjected to a first number of charge/discharge cycles and the one or more load-bearing battery cells may be subjected to a second number of charge/discharge cycles, such that the first number of charge/discharge cycles is greater than the second number of charge/discharge cycles. Additionally or alternatively, in some embodiments, the processor 602 includes hardware, software, firmware, and/or a combination thereof, that receives a physical characteristic of the reference battery cell from a sensing device (e.g., voltage sensor 306, temperature sensor 308, ultrasonic transducers 310), wherein the sensing device is positioned to measure a physical characteristic of the reference battery cell. Additionally or alternatively, in some embodiments, the processor 602 includes hardware, software, firmware, and/or a combination thereof, that determines a health condition of the reference battery cell based at least in part on the physical characteristic. Additionally or alternatively, in some embodiments, the processor 602 includes hardware, software, firmware, and/or a combination thereof, that performs an action with reference to the one or more load-bearing battery cells, based on the determined health condition of the reference battery cell.

In some embodiments, the battery management device 108 includes input/output circuitry 604 that provides output to the user and, in some embodiments, to receive an indication of a user input. In some embodiments, the input/output circuitry 604 is in communication with the processor 602 to provide such functionality. The input/output circuitry 604 may comprise one or more user interface(s) (e.g., user interface) and in some embodiments includes a display that comprises the interface(s) rendered as a web user interface, an application user interface, a user device, a backend system, or the like. The processor 602 and/or input/output circuitry 604 comprising the processor may be configured to control one or more functions of one or more user interface elements through computer program instructions (e.g., software and/or firmware) stored on a memory accessible to the processor (e.g., data storage media 606, and/or the like). In some embodiments, the input/output circuitry 604 includes or utilizes a user-facing application to provide input/output functionality to a client device and/or other display associated with a user.

In some embodiments, the battery management device 108 includes communications circuitry 608. The communications circuitry 608 includes any means such as a device or circuitry embodied in either hardware or a combination of hardware and software that is configured to receive and/or transmit data from/to a network and/or any other device, circuitry, or module in communication with the battery management device 108. In this regard, the communications circuitry 608 includes, for example in some embodiments, a network interface for enabling communications with a wired or wireless communications network. Additionally or alternatively in some embodiments, the communications circuitry 608 includes one or more network interface card(s), antenna(s), bus(es), switch(es), router(s), modem(s), and supporting hardware, firmware, and/or software, or any other device suitable for enabling communications via one or more communications network(s). Additionally or alternatively, the communications circuitry 608 includes circuitry for interacting with the antenna(s) and/or other hardware or software to cause transmission of signals via the antenna(s) or to handle receipt of signals received via the antenna(s). In some embodiments, the communications circuitry 608 enables transmission to and/or receipt of data from a client device in communication with the battery management device 108.

The battery monitoring circuitry 610 includes hardware, software, firmware, and/or a combination thereof, that supports various functionality associated with configuring and/or communicating with a battery pack (e.g., battery pack 110, battery pack 510). For example, in some embodiments, the battery monitoring circuitry 610 includes hardware, software, firmware, and/or a combination thereof to communicate with the battery pack according to an established protocol to provide appropriate configuration parameters and/or to receive data related to the operation of the battery pack, including electrical properties of the operating battery pack and load, physical layout of the battery pack, and/or electrical properties of any representative cell (e.g., representative cell 304) disposed in the battery pack. In some embodiments, the battery monitoring circuitry 610 includes a separate processor, specially configured field programmable gate array (FPGA), or a specially programmed application specific integrated circuit (ASIC).

The reference device circuitry 612 includes hardware, software, firmware, and/or a combination thereof, that supports various functionality associated with configuring and/or communicating with a reference cell device (e.g., reference cell device 102, reference cell device 502). For example, in some embodiments, the reference device circuitry 612 includes hardware, software, firmware, and/or a combination thereof to communicate with the reference cell device according to an established protocol to provide appropriate configuration parameters and/or to receive data related to the status of the reference cell device. In some embodiments, status may include, the physical properties of the reference cell and/or the representative cell as observed by sensing devices (e.g., voltage sensor 306, temperature sensor 308, ultrasonic transducers 310). In addition, status may include the real-time configuration of the battery charger/discharger (e.g., battery charger/discharger 106. In some embodiments, the reference device circuitry 612 may determine and facilitate transmission of command messages, for example, configuration commands to configure the battery charger/discharger to generate an output current (e.g., reference current 312) substantially equivalent to the load current (e.g., load current 114), or derived from the load current. In some embodiments, the reference device circuitry 612 includes a separate processor, specially configured field programmable gate array (FPGA), or a specially programmed application specific integrated circuit (ASIC).

Additionally or alternatively, in some embodiments, one or more of the sets of circuitry 602-612 are combinable. Additionally or alternatively, in some embodiments, one or more of the sets of circuitry perform some or all of the functionality described associated with another component. For example, in some embodiments, one or more sets of circuitry 602-714 are combined into a single module embodied in hardware, software, firmware, and/or a combination thereof. Similarly, in some embodiments, one or more of the sets of circuitry, for example battery monitoring circuitry 610, and/or reference device circuitry 612, is/are combined such that the processor 602 performs one or more of the operations described above with respect to each of these circuitry individually.

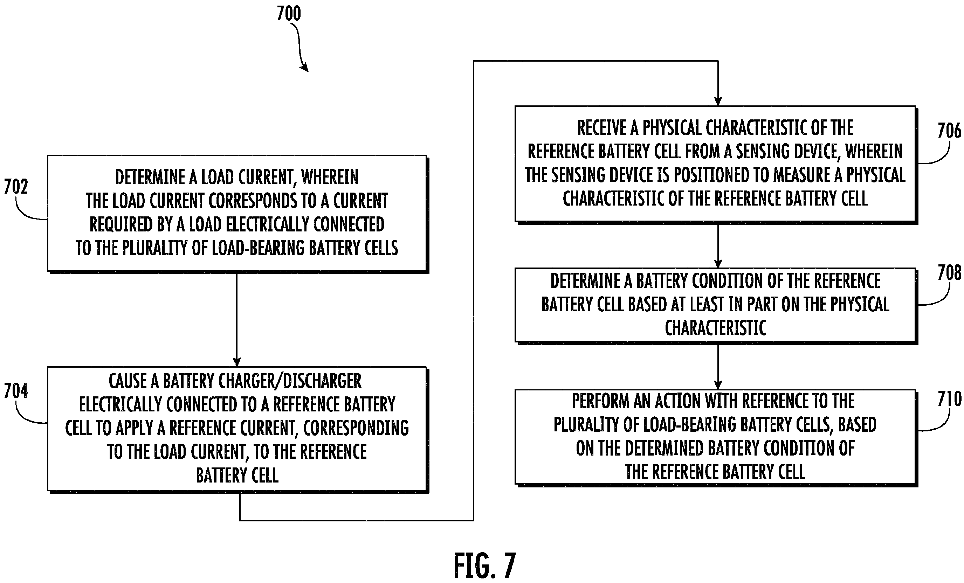

Referring now to FIG. 7, an example flow diagram illustrating an example method 700 for monitoring the health condition of one or more load-bearing cells (e.g., load-bearing cell 202) in a battery monitoring system (e.g., battery monitoring system 100) is illustrated, in accordance with some embodiments of the present disclosure. The example method 700 begins at block 702 when a battery management device (e.g., battery management device 108) determines a load current (e.g., load current 114), wherein the load current corresponds to a current required by a load (e.g., load 112) electrically connected to the one or more load-bearing battery cells. As described above, in some embodiments, the battery management device may be communicatively connected to a battery pack (e.g., battery pack 110, battery pack 510) through a battery pack communication channel (e.g., battery pack communication channel 116). A battery pack and/or sensing devices within or proximate the battery pack may measure the current required by the load. In some embodiments, the battery pack and/or sensing devices may transmit data related to the load current (e.g., the real-time current measurement) to the battery management device. In some embodiments, the battery pack and/or sensing devices may transmit the data related to the load current at regular intervals, by request, and/or based on the reading. For example, a battery pack may be configured to update the battery management device when the load current changes by a minimum amount, or rises or falls outside of a determined value range. In some embodiments, the battery monitoring device may request data related to the load current at a regular interval. In some embodiments, the battery monitoring device may request data related to the physical battery configuration and wiring, enabling the battery monitoring device to calculate the current at each load-bearing cell.

The example method 700 continues at block 704 when a battery management device causes a battery charger/discharger electrically connected to a reference battery cell (e.g., reference cell 302) to apply a reference current (e.g., reference current 312), substantially equivalent to the load current, or derived from the load current, to the reference battery cell. As described in relation to FIG. 3, a reference cell may be subjected to additional charge/discharge cycles when compared to the load-bearing cells. In some examples, loading the reference cell with a positive current such that the battery capacity is drained below a minimum level and then reversing the current such that the battery is charged to a certain maximum battery capacity, may qualify as a duty cycle. In some embodiments, a reference cell may be exposed to additional charge/discharge cycles before a reference cell module (e.g., reference cell module 104) is operating in a battery monitoring system 100. In some embodiments, the reference cell may be subjected to additional charge/discharge cycles after installation in a battery monitoring system 100, such as in an installation phase or during operation.

In some embodiments, the battery management device may send command and configuration messages via a communication channel (e.g., reference cell communication channel 118) to the reference cell module (e.g., reference cell module 104) and more particularly to the battery charger/discharger (e.g., battery charger/discharger 106). The command and control messages may cause the battery charger/discharger to update the current flow through the electrically reference cell based on the load current through the load-bearing cells 202. For example, in some embodiments, the battery management device may receive a load current from the battery pack 110 indicating the current flow through the individual load-bearing cells 202. The battery management device may then transmit command messages to the reference cell device to configure the battery charger/discharger to update the reference current to a value corresponding to the load current on each load-bearing cell.

At block 706, the battery management device receives a physical characteristic of the reference battery cell from a sensing device (e.g., voltage sensor 306, temperature sensor 308, ultrasonic transducers 310), wherein the sensing device is positioned to measure a physical characteristic of the reference battery cell. In some embodiments, the battery management device may receive measurement data from one or more sensors positioned on or near the reference cell and configured to measure physical characteristics related to the reference battery cell. Physical characteristics may include temperature interior to the reference battery cell, temperature external to the reference battery cell, pressure interior to the reference battery cell, pressure external to the reference battery cell, voltage across and/or current through the reference battery cell, internal resistance of the reference battery cell, gasses present in or near the reference battery cell, and other similar characteristics. These and other physical characteristics may be received by the battery management device via a communication channel, such as reference cell communication channel 118.

At block 708, the battery management device determines a health condition of the reference battery cell based at least in part on the physical characteristic. A battery management device may utilize the physical characteristics received from the reference cell device and sensing devices to determine a health condition of the reference battery cell. A health condition may be any determination related to the battery cell's ability to provide current to a load, receive a charging current, and/or otherwise properly function in a safe manner.

In one example, a battery management device may determine that a reference battery cell is experiencing or is about to experience a thermal runaway event. In a thermal runaway event, the movement of electrons and lithium ions in the battery cell may produce heat faster than the battery package can dissipate the generated heat. Once the internal temperature of the battery reaches a certain point, the temperature of the battery may rise uncontrollably until the battery combusts. A number of physical characteristics may be present at the onset and progression of thermal runaway in a battery cell. For example, there may be a sudden rise in temperature in or near the reference battery cell. Certain gasses may be present and detected at the onset and/or during a thermal runaway event. The pressure within the housing of the battery reference cell may increase. The physical size and/or shape of the reference battery cell may deform, for example, due to bulging. A reduction in the received amplitude of a transmitted ultrasonic wave through the battery reference cell may also indicate a change in battery health condition. Each of these detected conditions may be indicative of the health of the battery and thus represent a battery health condition.

In addition, a battery health condition may relate to changes in other physical characteristics of a battery reference cell. For example, an increase in the internal resistance of the battery reference cell, a change in the rate of charge or discharge, a change in the voltage drop across the battery reference cell, a change in the maximum power capacity of the battery reference cell, and other similar characteristics. These physical characteristics may also represent the health condition of a battery.

At block 710, the battery management device may perform an action with reference to the one or more load-bearing battery cells (e.g., load-bearing cell 202), based on the determined health condition of the reference battery cell. In some embodiments, the battery health condition determined in block 708 may be indicative of a condition likely to occur with relation to the one or more load-bearing battery cells. For example, if the reference battery cell has entered into thermal runaway, since the reference battery cell is slightly advanced in terms of charge/discharge cycles, the load-bearing battery cells may not be far behind. The battery management device may initiate a number of actions depending on the detected condition and/or progression of the condition. For example, the battery management device may initiate the disconnection of the load from the battery pack. In another example, the battery management device may alert the user and/or manufacture through a warning, indicating the condition of the battery. In some examples, the battery management device may initiate destructive mitigating actions to prevent progression of a dangerous battery condition. In some examples, the battery management device may initiate isolation and cutoff of a particular load-bearing cell in an instance in which it is determined a particular cell is susceptible to a health condition detrimental to the performance of the battery pack.

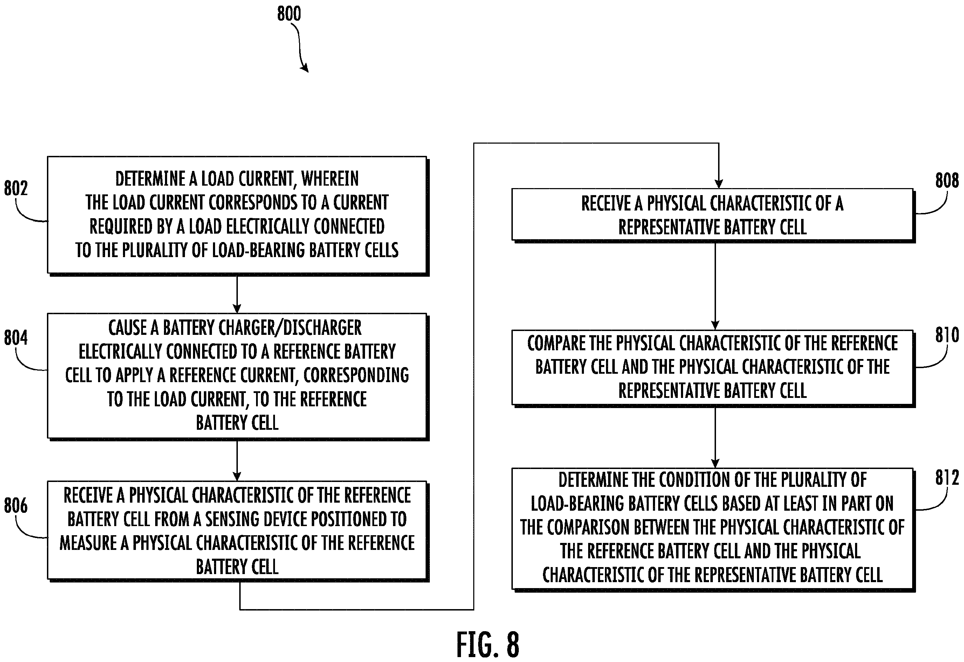

Referring now to FIG. 8, another example flow diagram illustrating an example method 800 for monitoring the health condition of one or more load-bearing cells (e.g., load-bearing cell 202) in a battery monitoring system (e.g., battery monitoring system 100) is illustrated, in accordance with some embodiments of the present disclosure. Similar to the example method 700, the example method 800 begins at block 802 when a battery management device (e.g., battery management device 108) determines a load current (e.g., load current 114), wherein the load current corresponds to a current required by a load (e.g., load 112) electrically connected to the one or more load-bearing battery cells. Also similar to the example method 700, at block 804 the battery management device causes a battery charger/discharger electrically connected to a reference battery cell (e.g., reference cell 302) to apply a reference current (e.g., reference current 312), substantially equivalent to the load current, or derived from the load current, to the reference battery cell. Further, as in the example method 700, at block 806, the battery management device receives a physical characteristic of the reference battery cell from a sensing device (e.g., voltage sensor 306, temperature sensor 308, ultrasonic transducers 310), wherein the sensing device is positioned to measure a physical characteristic of the reference battery cell.

At block 808, the battery management device additionally receives a physical characteristic of a representative battery cell (e.g., representative cell 304). As described in relation to FIG. 3, a representative battery cell may be substantially equivalent to the one or more load-bearing battery cells. Utilizing a battery cell that closely emulates the load-bearing cells, allows a battery management device to determine the physical characteristics of the representative battery cell, and use those physical characteristics to approximate, or represent the physical characteristics of the load-bearing cells. In some embodiments, the representative battery cell may be housed as part of the reference cell device (e.g., reference cell device 102) and be subjected to the reference current (e.g., reference current 312) representing the load current of the load (see FIG. 3). In some embodiments, the representative battery cell may be contained in the battery pack (e.g., battery pack 510) and be subjected to the load current just as the one or more load-bearing cells 202. Similar to the reference battery cell, one or more sensing devices may be placed on or near the representative battery cell, positioned to measure the physical characteristics of the representative battery cell. In some embodiments, the physical characteristics of the representative battery cell may be transmitted by the reference cell device, the battery pack, and/or the sensing devices themselves to the battery management device.

At block 810, the battery management device compares the physical characteristic of the reference battery cell and the physical characteristic of the representative battery cell. Once the physical characteristics observed by the sensing devices and transmitted to the battery management device are received, the battery management device may perform comparisons between the measurements. In some embodiments, the battery management device may directly compare the real-time physical characteristics of the representative battery cell to the reference battery cell. In some embodiments, the battery management device may compare physical characteristics averaged over time. In some embodiments, the battery management device may compare statistical representations of one or more physical characteristics of the representative battery cell and the reference battery cell.

At block 812, the battery management device determines the condition of the one or more load-bearing battery cells based at least in part on the comparison between the physical characteristic of the reference battery cell and the physical characteristic of the representative battery cell. In some embodiments, the reference battery cell may provide a standard for the diminishing battery over time because the reference battery cell has been subjected to additional charge/discharge cycles. In such an embodiment, the representative battery cell may be compared to the reference battery cell to detect a deviation from the standard battery aging, characterized by the reference battery cell. For example, in an instance in which sensing devices correlated with the reference battery cell have shown a steady voltage drop across the reference battery cell terminals, a sudden increase in voltage drop across the terminals of the representative battery cell may be an indication of a poor health condition, such as an increase in internal resistance. In another example, a reference battery cell may have shown a slow but steady reduction in overall battery capacity. A sudden and dramatic decrease in the overall battery capacity of the representative battery cell may also be an indication of a poor health condition. In some embodiments, the battery management device may determine that the one or more load-bearing battery cells are suffering from a similar health condition and perform an action based on that determination (e.g., shut-down power, performing further testing, etc.).

Many modifications and other embodiments of the inventions set forth herein will come to mind to one skilled in the art to which these inventions pertain having the benefit of teachings presented in the foregoing descriptions and the associated drawings. Although the figures only show certain components of the apparatus and systems described herein, it is understood that various other components may be used in conjunction with the system. Therefore, it is to be understood that the inventions are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the invention(s) set out in any claims that may issue from this disclosure.

Use of broader terms such as "comprises," "includes," and "having" should be understood to provide support for narrower terms such as "consisting of," "consisting essentially of," and "comprised substantially of' Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A system for monitoring a health condition of a battery cell, the system comprising:
a battery pack electrically connected to a load, the battery pack comprising one or more load-bearing battery cells;
a reference device comprising:
a reference battery cell;
a battery charger/discharger electrically connected to the reference battery cell; and
a sensing device positioned to measure a physical characteristic of the reference battery cell,
wherein the reference battery cell is subjected to a first number of charge/discharge cycles and the one or more load-bearing battery cells are subjected to a second number of charge/discharge cycles, such that the first number of charge/discharge cycles is greater than the second number of charge/discharge cycles; and
a battery management device communicatively connected to the battery pack and the reference device,
wherein the battery management device receives a load current corresponding to a current required by the load,
wherein the battery management device transmits a reference current corresponding to the load current, and
wherein the reference current is applied to the reference battery cell of the reference device, such that the health condition of the one or more load-bearing battery cells is determined based on the measured physical characteristic of the reference battery cell.

2. The system of Claim 1, wherein the reference device further comprises a housing defining a compartment physically separated from the one or more load-bearing battery cells, and wherein the reference battery cell is disposed within the compartment.

3. The system of Claim 2, wherein the reference battery cell is subjected to charge/discharge cycles, such that the first number of charge/discharge cycles is greater than the second number of charge/discharge cycles, before being disposed within the compartment of the reference device.

4. The system of Claim 1, wherein the sensing device comprises at least one of an ultrasonic transducer, a voltage sensor, and a temperature sensor.

5. The system of Claim 1, wherein the reference device further comprises a representative battery cell,
wherein the representative battery cell is subjected to a third number of charge/discharge cycles, wherein the third number of charge/discharge cycles is substantially equivalent to the second number of charge/discharge cycles associated with the number of charge/discharge cycles of the one or more load-bearing battery cells, and
wherein the third number of charge/discharge cycles is less than the first number of charge/discharge cycles associated with the number of charge/discharge cycles of the reference battery cell.

6. The system of Claim 5, wherein a second sensing device is positioned proximate the representative battery cell to measure a physical characteristic of the representative battery cell.

7. The system of Claim 6, wherein a comparison is made between the physical characteristic of the reference battery cell and the physical characteristic of the representative battery cell, and wherein the health condition of the one or more load-bearing battery cells is determined based at least in part on the comparison.

8. The system of Claim 7, wherein the physical characteristic compared is at least one of an amplitude of a received ultrasonic signal, a voltage difference across a first and second terminal of the battery cell, and a temperature proximate the battery cell.

9. A reference device for monitoring a health condition of one or more load-bearing cells subjected to a load current, the reference device comprising:
a reference battery cell;
a battery charger/discharger electrically connected to the reference battery cell; and
a sensing device positioned to measure a physical characteristic of the reference battery cell,
wherein the reference battery cell is subjected to a first number of charge/discharge cycles and the one or more load-bearing battery cells are subjected to a second number of charge/discharge cycles, such that the first number of charge/discharge cycles is greater than the second number of charge/discharge cycles; and
wherein a reference current corresponding to the load current is applied to the reference battery cell, such that the health condition of the one or more load-bearing battery cells is determined based on the measured physical characteristic of the reference battery cell.

10. The reference device of Claim 9, further comprising a representative battery cell,
wherein the representative battery cell is subjected to a third number of charge/discharge cycles, such that the third number of charge/discharge cycles is substantially equivalent to the second number of charge/discharge cycles associated with the number of charge/discharge cycles of the one or more load-bearing battery cells, and
wherein the third number of charge/discharge cycles is less than the first number of charge/discharge cycles associated with the number of charge/discharge cycles of the reference battery cell.

11. The reference device of Claim 10, wherein a second sensing device is positioned proximate the representative battery cell to measure a physical characteristic of the representative battery cell.

12. The reference device of Claim 11, wherein a comparison is made between the physical characteristic of the reference battery cell and the physical characteristic of the representative battery cell, and wherein the health condition of the one or more load-bearing battery cells is determined based at least in part on the comparison.

13. A method for monitoring one or more load-bearing battery cells, the method comprising:
determining a load current, wherein the load current corresponds to a current required by a load electrically connected to the one or more load-bearing battery cells;
causing a battery charger/discharger electrically connected to a reference battery cell to apply a reference current, substantially equivalent to the load current, to the reference battery cell,
wherein the reference battery cell is subjected to a first number of charge/discharge cycles and the one or more load-bearing battery cells are subjected to a second number of charge/discharge cycles, such that the first number of charge/discharge cycles is greater than the second number of charge/discharge cycles;
receiving a physical characteristic of the reference battery cell from a sensing device, wherein the sensing device is positioned to measure a physical characteristic of the reference battery cell;
determining a health condition of the reference battery cell based at least in part on the physical characteristic; and
performing an action with reference to the one or more load-bearing battery cells, based on the health condition of the reference battery cell.

14. The method of Claim 13, further comprising:
receiving a physical characteristic of a representative battery cell,
wherein the representative battery cell is subjected to a third number of charge/discharge cycles, such that the third number of charge/discharge cycles is substantially equivalent to the second number of charge/discharge cycles associated with the number of charge/discharge cycles of the one or more load-bearing battery cells, and
wherein the third number of charge/discharge cycles is less than the first number of charge/discharge cycles associated with the number of charge/discharge cycles of the reference battery cell, and
wherein a second sensing device is positioned proximate the representative battery cell to measure a physical characteristic of the representative battery cell;
comparing the physical characteristic of the reference battery cell and the physical characteristic of the representative battery cell; and
determining the health condition of the one or more load-bearing battery cells based at least in part on the comparison between the physical characteristic of the reference battery cell and the physical characteristic of the representative battery cell.

15. The method of Claim 13, wherein performing an action with reference to the one or more load-bearing battery cells comprises electrically disconnecting the load from the one or more load-bearing cells.
